# FASCICULE DE BREVET EUROPEEN

(11) **EP 2 981 159 B1**
(45) Date de publication et mention de la délivrance du brevet: **03.04.2019**
(21) Numéro de dépôt: 15178495.6
(22) Date de dépôt: 27.07.2015
(51) Int. Cl.: H05K 5/02

(54) **BOÎTIER ÉLECTRONIQUE PRÉSENTANT UN SOCLE**
ELEKTRONIKGEHÄUSE MIT EINEM SOCKEL
ELECTRONIC BOX HAVING A BASE

(30) Priorité: 28.07.2014 FR 1457274
(43) Date de publication de la demande: 03.02.2016
(73) Titulaire: Delta Dore, 35270 Bonnemain (FR)
(72) Inventeur: SCHREIBER, Yannick, 35270 BONNEMAIN (FR)
(74) Mandataire: Cabinet Le Guen Maillet

(56) Documents cités:
- DE-U- 1 991 579
- US-A- 3 734 342

## Description

La présente invention concerne un boîtier électronique pouvant être fixé sur un support tel qu'un mur.

La fixation d'un boîtier électronique sur un support tel qu'un mur peut être relativement ardue. Par exemple dans le cas d'un système d'alarme, la sirène dudit système d'alarme est fixée à un mur vertical.

La fixation est réalisée par un technicien qui doit tenir fermement la sirène contre le mur tout en mettant en place des vis de fixation traversant la sirène et se fixant dans le mur.

Le maintien de la sirène est ardu car elle est relativement lourde et encombrante et l'installation doit souvent être réalisée par deux techniciens, le premier maintenant la sirène pendant que l'autre la fixe.

Le document DE-U-19 91 579 divulgue un boîtier selon le préambule de la revendication 1.

Un objet de la présente invention est de proposer un boîtier électronique, de préférence une sirène, qui peut être fixé aisément sur un support par un technicien.

A cet effet, est proposé un boîtier électronique comportant :
- un socle comprenant une plaque destinée à être fixée à un support et au moins une colonnette principale solidaire de la plaque, et
- un boîtier comportant une paroi de fond et une paroi frontale et portant des composants électroniques,
la paroi de fond est prévue pour venir en contact avec la plaque et présente pour la ou chaque colonnette principale, un alésage traversant permettant le passage de ladite colonnette principale, et
la paroi frontale présente pour la ou chaque colonnette principale, un perçage traversant à travers lequel, un moyen principal de solidarisation a accès à ladite colonnette principale pour assurer la solidarisation de ladite colonnette principale et de la paroi frontale,
le boîtier électronique étant caractérisé en ce que la paroi frontale présente une partie fixe solidaire de la paroi de fond, et une partie amovible dans laquelle sont réalisés les perçages traversants, en ce que le boîtier électronique comporte au moins une colonnette secondaire solidaire de la paroi de fond, et en ce que la partie amovible présente pour chaque colonnette secondaire, un autre perçage traversant à travers lequel, un moyen secondaire de solidarisation a accès à ladite colonnette secondaire pour assurer la solidarisation de ladite colonnette secondaire et de la partie amovible.

Avantageusement, l'extrémité libre de la ou chaque colonnette principale présente un épaulement sur lequel repose le perçage traversant correspondant.

Avantageusement, l'extrémité libre de chaque colonnette secondaire présente un épaulement sur lequel repose ledit autre perçage traversant correspondant.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente une vue en perspective d'un boîtier électronique selon l'invention, et
la Fig. 2 montre le boîtier électronique en coupe selon le plan II de la Fig. 1.

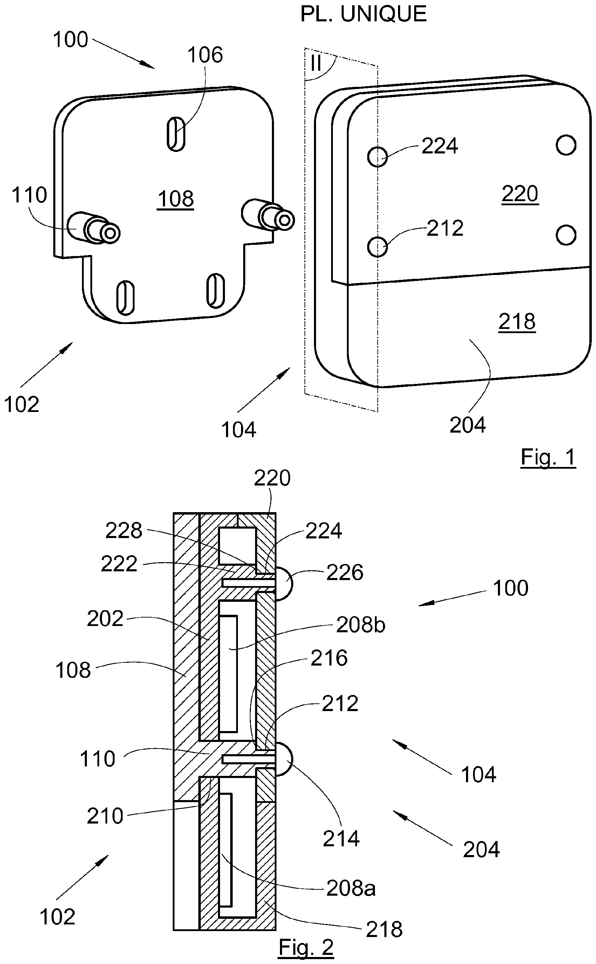

La Fig. 1 montre un boîtier électronique 100, qui est ici une sirène d'un système d'alarme et qui comporte:
- un socle 102, et
- un boîtier 104.

Le socle 102 comprend une plaque 108 destinée à être fixée à un support, tel qu'un mur, et au moins une colonnette principale 110 solidaire de la plaque 108 et s'étendant dans la direction opposée au support. Dans le reste de la description il est fait mention de deux colonnettes principales 110, mais il pourrait y en avoir qu'une seule.

La plaque 108 est destinée à être fixée sur le support et comporte à cet effet des moyens de fixation 106 adaptés qui sont ici des trous oblongs réalisés dans la plaque 108 et permettant la mise en place de vis de fixation se vissant dans le support. En particulier et avantageusement la plaque 108 ne porte pas de composants électroniques.

La plaque 108 est relativement légère et peut donc être fixée facilement sur le support par un seul technicien.

Le socle 102 ne porte aucun composant électronique.

La Fig. 2 montre le boîtier électronique 100 en coupe.

Le boîtier 104 comporte une paroi de fond 202 et une paroi frontale 204 et il porte des composants électroniques qui sont représentés ici par des rectangles 208a-b. Le boîtier 104 peut ainsi constituer une unité autonome.

La paroi de fond 202 est prévue pour venir en contact avec la plaque 108 et présente pour chaque colonnette principale 110, un alésage traversant 210 permettant le passage de ladite colonnette principale 110.

La paroi frontale 204 présente également pour chaque colonnette principale 110, un perçage traversant 212 à travers lequel, un moyen principal de solidarisation 214 a accès à ladite colonnette principale 110 pour assurer la solidarisation de ladite colonnette principale 110 et de la paroi frontale 204. Dans le mode de réalisation de l'invention présenté ici, le moyen principal de solidarisation 214 est une vis principale 214 qui est vissée dans la colonnette principale 110 dans un alésage que celle-ci présente à cet effet.

La mise en place du boîtier électronique 100 consiste après avoir fixé le socle 102 sur le support à emmancher les alésages traversants 210 sur les colonnettes principales 110 puis à mettre en place les moyens principaux de solidarisation 214 correspondants à chaque colonnette principale 110.

L'emmanchement du boîtier 104 sur les colonnettes principales 110 permet de libérer le technicien puisque le boîtier 104 est maintenu par les colonnettes principales 110, le temps de la fixation finale par les moyens principaux de solidarisation 214.

Pour assurer une meilleure stabilisation du boîtier 104 sur les colonnettes principales 110, l'extrémité libre de chaque colonnette principale 110 présente un épaulement 216 sur lequel repose le perçage traversant 212 correspondant.

Dans le mode de réalisation de l'invention présenté sur les Figs., la paroi frontale 204 présente une partie fixe 218 et une partie amovible 220.

La partie fixe 218 est solidaire de la paroi de fond 202.

La partie amovible 220 peut être détachée pour permettre un accès à l'intérieur du boîtier 104 par exemple pour remplacer une batterie 208b.

Les perçages traversants 212 sont réalisés dans la partie amovible 220.

Pour assurer la fixation de la partie amovible 220 lorsque les moyens principaux de solidarisation 214 ne sont pas en place, le boîtier 104 présente au moins une colonnette secondaire 222 solidaire de la paroi de fond 202 et s'étendant dans la direction opposée au support.

La partie amovible 220 présente également pour chaque colonnette secondaire 222, un autre perçage traversant 224 à travers lequel un moyen secondaire de solidarisation 226 a accès à ladite colonnette secondaire 222 pour assurer la solidarisation de ladite colonnette secondaire 222 et de la partie amovible 220. Dans le mode de réalisation de l'invention présenté ici, le moyen secondaire de solidarisation 226 est une vis secondaire 226 qui est vissée dans la colonnette secondaire 222 dans un alésage que celle-ci présente à cet effet.

Pour assurer une meilleure stabilisation de la partie amovible 220 sur les colonnettes secondaires 222, l'extrémité libre de chaque colonnette secondaire 222 présente un épaulement 228 sur lequel repose ledit autre perçage traversant 224 correspondant.

Bien entendu, la présente invention n'est pas limitée aux exemples et modes de réalisation décrits et représentés, mais elle est susceptible de nombreuses variantes accessibles à l'homme de l'art.

## Revendications

1. Boîtier électronique (100) comportant :
- un socle (102) comprenant une plaque (108) destinée à être fixée à un support et au moins une colonnette principale (110) solidaire de la plaque (108), et
- un boîtier (104) comportant une paroi de fond (202) et une paroi frontale (204) et portant des composants électroniques (208),
la paroi de fond (202) est prévue pour venir en contact avec la plaque (108) et présente pour la ou chaque colonnette principale (110), un alésage traversant (210) permettant le passage de ladite colonnette principale (110), et
la paroi frontale (204) présente pour la ou chaque colonnette principale (110), un perçage traversant (212) à travers lequel, un moyen principal de solidarisation (214) a accès à ladite colonnette principale (110) pour assurer la solidarisation de ladite colonnette principale (110) et de la paroi frontale (204),
le boîtier électronique (100) étant **caractérisé en ce que** la paroi frontale (204) présente une partie fixe (218) solidaire de la paroi de fond (202), et une partie amovible (220) dans laquelle sont réalisés les perçages traversants (212), **en ce que** le boîtier électronique (100) comporte au moins une colonnette secondaire (222) solidaire de la paroi de fond (202), et **en ce que** la partie amovible (220) présente pour chaque colonnette secondaire (222), un autre perçage traversant (224) à travers lequel, un moyen secondaire de solidarisation (226) a accès à ladite colonnette secondaire (222) pour assurer la solidarisation de ladite colonnette secondaire (222) et de la partie amovible (220).

2. Boîtier électronique (100) selon la revendication 1, **caractérisé en ce que** l'extrémité libre de la ou chaque colonnette principale (110) présente un épaulement (216) sur lequel repose le perçage traversant (212) correspondant.

3. Boîtier électronique (100) selon l'une des revendications 1 ou 2, **caractérisé en ce que** l'extrémité libre de chaque colonnette secondaire (222) présente un épaulement (228) sur lequel repose ledit autre perçage traversant (224) correspondant.

## Patentansprüche

1. Elektronikgehäuse (100), umfassend:
- einen Sockel (102), umfassend eine Platte (108), die dazu bestimmt ist, an einem Träger befestigt zu werden, und mindestens einen Hauptstift (110), der mit der Platte (108) fest verbunden ist, und
- ein Gehäuse (104), das eine Rückwand (202) und eine Vorderwand (204) aufweist und das elektronische Komponenten (208) trägt,
die Rückwand (202) ist vorgesehen, um mit der Platte (108) in Kontakt zu kommen und weist für den oder jeden Hauptstift (110) eine Durchgangsbohrung (210) auf, die den Durchgang des Hauptstiftes (110) ermöglicht, und
die Vorderwand (204) weist für den oder jeden Hauptstift (110) eine Durchgangsbohrung (212) auf, durch die ein Hauptbefestigungsmittel (214) Zugang zu dem Hauptstift (110) hat, um das Befestigen des Hauptstiftes (110) und der Vorderwand (204) zu gewährleisten,
wobei das Elektronikgehäuse (100) **dadurch gekennzeichnet ist, dass** die Vorderwand (204) einen festen Teil (218), der mit der Rückwand (202) fest verbunden ist, und einen abnehmbaren Teil (220) aufweist, in dem die Durchgangsbohrungen (212) ausgeführt sind, dadurch, dass das Elektronikgehäuse (100) mindestens einen Sekundärstift (222) aufweist, der mit der Rückwand (202) fest verbunden ist, und dadurch, dass der abnehmbare Teil (220) für jeden Sekundärstift (222) eine andere Durchgangsbohrung (224) aufweist, durch die ein Sekundärbefestigungsmittel (226) Zugang zu dem Sekundärstift (222) hat, um das Befestigen des Sekundärstiftes (222) und des abnehmbaren Teils (220) zu gewährleisten.

2. Elektronikgehäuse (100) nach Anspruch 1, **dadurch gekennzeichnet, dass** das freie Ende des oder jedes Hauptstiftes (110) eine Schulter (216) aufweist, auf der die entsprechende Durchgangsbohrung (212) ruht.

3. Elektronikgehäuse (100) nach einem der Ansprüche 1 oder 2, **dadurch gekennzeichnet, dass** das freie Ende von jedem Sekundärstift (222) eine Schulter (228) aufweist, auf der die entsprechende andere Durchgangsbohrung (224) ruht.

## Claims

1. Electronic box (100) comprising:
- a base (102) having a plate (108) intended to be fixed to a support and at least a main column (110) fixed to the plate (108), and
- a case (104) comprising a bottom wall (202) and a front wall (204) and carrying electronic components (208),
the bottom wall (202) is intended to come in contact with the plate (108) and has for the or each main column (110), a through bore (210) allowing the passage of said main column (110), and
the front wall (204) has for the or each main column (110), a main through hole (212) through which, a main mean of fixing (214) has access to said main column (110) to ensure the fixation of said main column (110) and of the front wall (204),
the electronic box (100) being **characterized in that** the front wall (204) has a fixed part (218) fixed to the bottom wall (202), and a removable part (220) in which the through holes (212) are realized, **in that** the electronic box (100) comprises at least one secondary column (222) fixed to the bottom wall (202), and **in that** the removable part (220) has for each secondary column (222), another through hole (224) through which a secondary mean of fixing (226) has access to said secondary column (222) to ensure the fixation of said secondary column (222) and the removable part (220).

2. Electronic box (100) according to claim 1, **characterized in that** the free end of the or each main column (110) has a shoulder (216) on which the corresponding through hole (212) lies.

3. Electronic box (100) according to any one of the claims 1 or 2, **characterized in that** the free end of each secondary column (222) has a shoulder (228) on which corresponding said other through hole (224) lies.
